# FASCICULE DE BREVET EUROPEEN

(11) **EP 2 428 985 B1**
(45) Date de publication et mention de la délivrance du brevet: **17.04.2013**
(21) Numéro de dépôt: 11180701.2
(22) Date de dépôt: 09.09.2011
(51) Int. Cl.: H01L 21/336, H01L 29/78, H01L 21/762, H01L 29/165

(54) **Procédé de fabrication d'un transistor MOS à canal contraint**
Verfahren zur Herstellung eines MOS-Transistors mit verspanntem Kanal
Method for manufacturing a strained channel MOS transistor

(30) Priorité: 13.09.2010 FR 1057253
(43) Date de publication de la demande: 14.03.2012
(73) Titulaire: STMicroelectronics (Grenoble 2) SAS, 38000 Grenoble (FR); COMMISSARIAT A L'ENERGIE ATOMIQUE ET AUX ENERGIES ALTERNATIVES, 75015 Paris (FR)
(72) Inventeur: Morand, Yves, 38000 Grenoble (FR); Poiroux, Thierry, 38500 Voiron (FR); Barbe, Jean-Charles, 38160 Izeron (FR)
(74) Mandataire: de Beaumont, Michel

(56) Documents cités:
- US-A1- 2006 043 424
- US-A1- 2006 220 147
- US-A1- 2007 114 632
- US-A1- 2007 228 488
- US-A1- 2008 277 740
- US-A1- 2010 019 322

## Description

### Domaine de l'invention

La présente invention concerne un procédé de fabrication de transistors MOS à canal contraint.

### Exposé de l'art antérieur

Les transistors MOS intégrés sont formés en surface de substrats semiconducteurs. Ils sont constitués d'une grille isolée formée en surface du substrat et de régions de source et de drain formées dans le substrat, de part et d'autre de la grille.

Dans un substrat semiconducteur, les porteurs mis en jeu dans des transistors à canal N ou à canal P ne se déplacent pas à la même vitesse. Pour améliorer la mobilité des porteurs, il est connu de former des régions de canal différentes en fonction du type de porteurs utilisé. Notamment, il est connu que la mobilité des porteurs dans des transistors MOS à canal P est plus importante lorsque le canal est en silicium-germanium plutôt qu'en silicium. Pour des transistors MOS à canal N, un substrat de silicium est mieux adapté. On peut ainsi prévoir de former, sur une même structure, des régions de canal en silicium-germanium pour les transistors MOS à canal P et des régions de canal en silicium pour les transistors MOS à canal N.

Il est également connu que, sur un même substrat, la mobilité de certains porteurs peut être améliorée en appliquant une contrainte localement au niveau du canal des transistors concernés. Ceci est notamment décrit dans la publication intitulée "Electron Mobility Model for Strained-Si Devices", de Dhar et al., TED 52 (2005).

De nombreux procédés ont été proposés pour appliquer une contrainte localement sur le canal de certains transistors. Notamment, il a été proposé de modifier ou de remplacer le matériau constituant les régions de source et de drain de façon à ce que le matériau modifié ou de remplacement applique une contrainte dans la longueur du canal du transistor.

Cependant, les procédés connus sont généralement relativement complexes à mettre en oeuvre et impliquent un nombre d'étapes de fabrication supplémentaires important par rapport aux procédés classiques de formation de transistors MOS.

On connaît également le document US 2008/0277740 qui décrit un procédé de fabrication de transistors MOS à canal contraint qui présente ses inconvénients propres.

### Résumé

Un objet d'un mode de réalisation de la présente invention est de prévoir un procédé de formation de transistors MOS à canal contraint relativement simple et n'impliquant que peu d'étapes supplémentaires par rapport aux procédés connus.

Un autre objet d'un mode de réalisation de la présente invention est de prévoir un procédé compatible avec la formation de grilles de transistor MOS en surface d'un même substrat en des matériaux différents.

Ainsi, un mode de réalisation de la présente invention prévoit un procédé de fabrication d'un transistor MOS à canal contraint, comprenant les étapes suivantes : (a) former, en surface d'un substrat semiconducteur, un transistor MOS comprenant des régions de source et de drain et une grille sacrificielle isolée qui s'étend en partie sur des zones d'isolement entourant le transistor ; (b) former une couche de matériau diélectrique dont la surface supérieure affleure la surface supérieure de la grille sacrificielle ; (c) éliminer la grille sacrificielle ; (d) graver au moins une partie supérieure des zones d'isolement découvertes pour y former des tranchées ; (e) remplir les tranchées d'un matériau adapté à appliquer une contrainte au substrat ; et (f) former, dans l'espace laissé libre par la grille sacrificielle, une grille isolée de transistor MOS.

Selon un mode de réalisation de la présente invention, l'étape (e) est réalisée en déposant un matériau adapté à appliquer une contrainte sur le substrat sur l'ensemble de la structure puis en gravant l'excédent de ce matériau situé en dehors des tranchées.

Selon un mode de réalisation de la présente invention, les tranchées s'étendent jusqu'au substrat semiconducteur, ou jusqu'à un support de structure semiconducteur sur isolant, et le remplissage des tranchées à l'étape (e) est réalisé par épitaxie du matériau adapté à appliquer une contrainte à partir du fond des tranchées.

Selon un mode de réalisation de la présente invention, le substrat est un substrat massif.

Selon un mode de réalisation de la présente invention, le substrat est un substrat de type semiconducteur sur isolant.

Selon un mode de réalisation de la présente invention, le matériau adapté à appliquer une contrainte sur le substrat est du nitrure de silicium, du silicium-germanium, ou un matériau dont la structure est adaptée à fluer par suite d'un recuit.

Selon un mode de réalisation de la présente invention, l'étape (f) est précédée ou suivie d'une étape d'élimination de la couche de matériau diélectrique.

Un mode de réalisation de la présente invention prévoit un circuit intégré comprenant au moins un transistor MOS formé par le procédé ci-dessus.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
les figures 1A à 1C sont, respectivement, une vue en coupe selon la largeur, selon la longueur, et une vue de dessus simplifiée, d'un transistor MOS formé par un procédé selon un mode de réalisation de la présente invention ;
les figures 2A à 7A, respectivement 2B à 7B, sont des vues en coupe selon la largeur d'un transistor, respectivement selon la longueur du transistor, illustrant des résultats d'étapes d'un procédé selon un mode de réalisation de la présente invention ; et
la figure 8A, respectivement 8B, est une vue en coupe selon la largeur d'un transistor MOS, respectivement selon la longueur, résultant d'une variante d'un procédé selon un mode de réalisation de la présente invention.

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

### Description détaillée

Dans les figures qui seront décrites ci-après, un seul transistor MOS est représenté en surface d'un substrat. On notera que, de façon classique, de nombreux transistors MOS sont formés en surface d'un même substrat, en association par exemple avec d'autres composants électroniques.

De plus, dans la suite de la description, lorsque l'on parlera d'un matériau appliquant une contrainte sur le substrat semiconducteur adjacent, la contrainte considérée pourra être une contrainte en tension ou une contrainte en compression, en fonction de l'application désirée et de la mobilité des porteurs souhaitée.

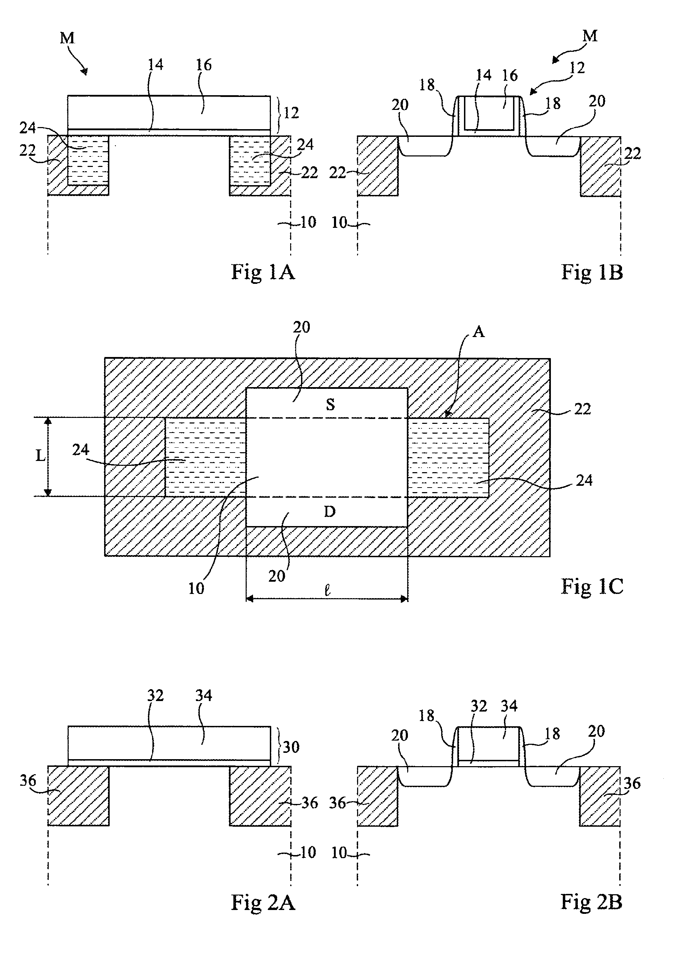

Les figures 1A, 1B et 1C illustrent, respectivement en coupe selon deux directions perpendiculaires en surface d'un substrat et en vue de dessus simplifiée, un transistor MOS M obtenu par un procédé selon un mode de réalisation. La vue de dessus de la figure 1C est simplifiée en ce que la grille isolée du transistor n'y est pas représentée. De façon classique, on appelle longueur du transistor la distance de canal entre les régions de source et de drain (longueur de canal, L en figure 1C), et largeur d'un transistor la dimension dans une direction, en surface du substrat, perpendiculaire à sa longueur (1 en figure 1C). On notera que, dans les figures, la longueur du transistor représenté est inférieure à la largeur de celui-ci. L'inverse est également possible.

Le transistor M est formé en surface d'un substrat semiconducteur 10. Plus précisément, le transistor M est formé dans une zone active A constituée d'une portion du substrat semiconducteur 10 entourée d'une région d'isolement 22, formée en surface du substrat. A titre d'exemple, les régions d'isolement 22 peuvent être des régions de type "STI" (Shallow Trench Isolation, tranchées peu profondes). Le transistor comprend, en surface de la zone active A, une grille isolée 12 comprenant une couche inférieure isolante 14 surmontée d'une couche de matériau conducteur 16, par exemple du silicium polycristallin dopé.

Tout autour de la grille isolée 12 sont formés des espaceurs 18. Des régions de source et de drain 20 sont formées dans le substrat semiconducteur 10, en surface de celui-ci, de part et d'autre de la grille 12 dans la longueur du transistor M. Les régions isolantes 22 sont, dans l'exemple représenté, au contact des régions de source et de drain 20.

Dans la largeur de la grille de transistor 12 (figure 1A), de part et d'autre de la grille isolée 12 s'étendent les régions d'isolement 22 qui permettent d'isoler les différents transistors MOS formés en surface d'un même substrat les uns des autres. En dessous de la grille de transistor 12, au contact avec les régions d'isolement 22, sont formées des régions 24 en un matériau adapté à appliquer une contrainte sur le substrat adjacent. Notamment, le matériau 24 permet d'appliquer une contrainte sur la région du substrat 10 formée en dessous de la grille de transistor 12, au niveau du canal du transistor M.

Dans l'exemple représenté, les portions 24 en un matériau adapté à appliquer une contrainte sur le substrat adjacent ne s'étendent pas jusqu'au fond des régions d'isolement 22. On notera que les portions 24 peuvent également s'étendre jusqu'au fond des régions d'isolement 22.

Le procédé décrit ci-après permet de former, sur un même substrat semiconducteur, des transistors MOS tel que celui des figures 1A et 1B, mais également des transistors MOS classiques, dans lesquels le matériau semiconducteur formant la portion de canal du transistor n'est pas contrainte. Pour cela, il suffit que les transistors classiques soient masqués lors de la fabrication des transistors à canal contraint. On pourra également prévoir de former des grilles de transistor à canal contraint et à canal non-contraint en des matériaux différents gravables sélectivement l'un par rapport à l'autre. Le procédé décrit ci-après est également compatible avec la formation de grilles de transistor MOS de structures ou de matériaux différents en surface d'un même substrat.

Les figures 2A à 7A, respectivement 2B à 7B, sont des vues en coupe selon la largeur d'un transistor, respectivement selon la longueur du transistor, de résultats d'étapes d'un procédé selon un mode de réalisation.

A l'étape illustrée en figures 2A et 2B, un transistor MOS classique, fini, est formé en surface d'un substrat semiconducteur 10. Ce transistor comprend une grille isolée 30 comportant une couche inférieure isolante 32 et une couche supérieure 34 en un matériau conducteur tel que du silicium polycristallin dopé. Des espaceurs 18 sont formés tout autour de la grille isolée 30. Les régions de source et de drain sont formées, de part et d'autre des espaceurs 18 dans la longueur du transistor, dans le substrat semiconducteur 10, en surface de celui-ci, et peuvent être siliciurées.

Le transistor est formé dans une zone active définie dans le substrat 10 par des régions d'isolement 36. Ainsi, dans la largeur du transistor, de part et d'autre de la région de canal formée en dessous de la grille isolée, s'étendent les régions isolantes 36 en surface de celui-ci. A titre d'exemple, les régions isolantes 36 peuvent être des régions de type STI (Shallow Trench Isolation), par exemple en oxyde de silicium. De façon classique, la grille isolée 30 s'étend légèrement en surface des régions isolantes 36.

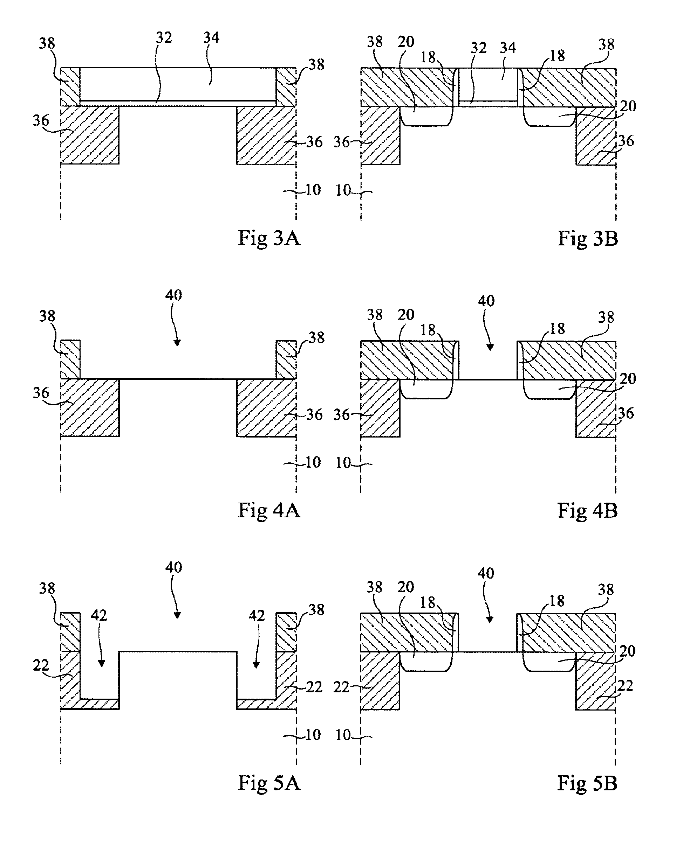

A l'étape illustrée en figures 3A et 3B, une couche de matériau isolant 38, gravable sélectivement par rapport au matériau formant les régions d'isolement 36, est formée sur la structure de façon à recouvrir l'ensemble du dispositif. La surface de la couche isolante 38 est au même niveau que la surface de la grille isolée 30 : la surface de la couche 38 affleure la surface de la grille 30.

Pour former la couche isolante 38, on peut par exemple réaliser un dépôt pleine plaque d'un matériau isolant puis réaliser un polissage mécano-chimique (CMP) ou une gravure de façon à faire apparaître la surface supérieure de la grille isolée 30. A titre d'exemple, si les régions isolantes 36 sont en oxyde de silicium, la couche isolante 38 pourra être en nitrure de silicium gravable sélectivement par rapport à l'oxyde de silicium. D'autres matériaux pourront bien sûr être envisagés.

A l'étape illustrée en figures 4A et 4B, une ou plusieurs gravures ont été réalisées de façon à éliminer le matériau conducteur 34 et le matériau isolant 32 de la grille isolée 30. Ceci permet de former, dans l'enceinte du matériau diélectrique 38, une tranchée 40 à l'emplacement de la grille isolée 30.

A l'étape illustrée en figures 5A et 5B, une gravure anisotrope ou isotrope est réalisée de façon à éliminer une portion des régions d'isolement 36 correspondant à la portion qui n'est pas protégée par le matériau diélectrique 38. Cette gravure permet d'obtenir des tranchées 42 dans les régions d'isolement 36. On notera que la gravure réalisée pour obtenir le dispositif des figures 5A et 5B peut être la même gravure que celle utilisée, à l'étape des figures 4A et 4B, pour éliminer le matériau isolant de la grille isolée 30, si cette gravure est compatible avec le matériau des régions d'isolement 36.

Dans l'exemple représenté en figures 5A et 5B, les tranchées 42 ne s'étendent pas jusqu'au fond des régions d'isolement 36. On notera que l'on pourra également prévoir que ces tranchées s'étendent jusqu'au fond des régions d'isolement 36.

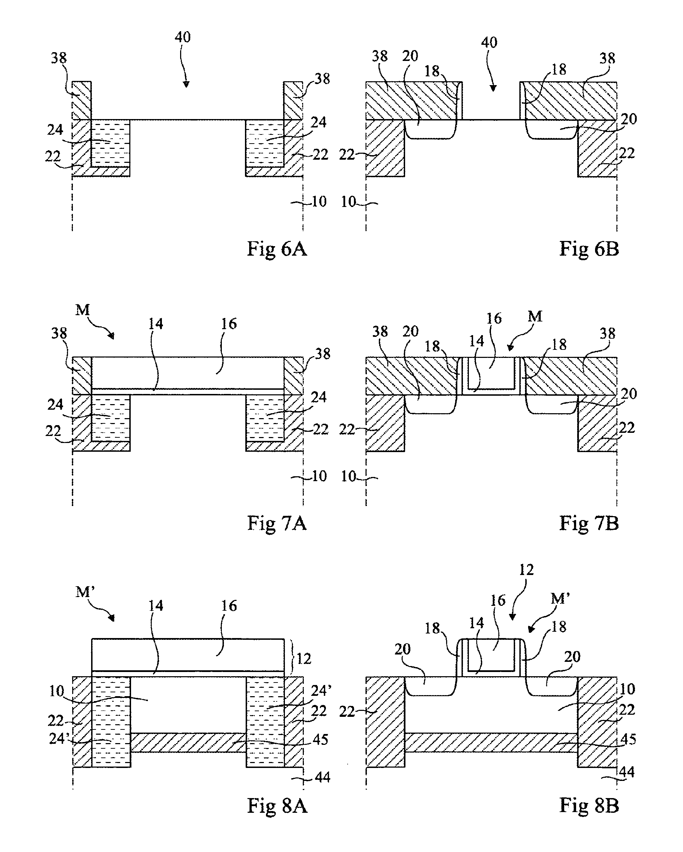

A l'étape illustrée en figures 6A et 6B, les tranchées 42 ont été remplies d'un matériau 24 adapté à appliquer une contrainte sur le substrat adjacent, et notamment sur la région de canal constituée du substrat semiconducteur 10 situé entre les régions de matériau contraignant 24. Le matériau 24 peut être formé de plusieurs façons. Par exemple, on peut prévoir de déposer ce matériau sur l'ensemble de la structure puis de graver celui-ci de façon à ce que sa surface supérieure soit au même niveau, ou sensiblement au même niveau, que la surface supérieure du substrat 10.

On peut également prévoir, si les tranchées 42 s'étendent jusqu'au fond des régions isolantes 36, de former les régions 24 en réalisant une épitaxie d'un matériau semiconducteur adapté à appliquer une contrainte sur le substrat adjacent à partir du substrat 10.

Le matériau des régions 24 peut être par exemple du silicium-germanium (qui peut être épitaxié), du nitrure de silicium (Si₃N₄), ou tout autre matériau, par exemple un matériau dont la structure est adaptée à fluer suite à l'application d'un recuit, par exemple un oxyde dopé au bore ou au phosphore recuit à une température supérieure à 850°C, tel que décrit dans la publication intitulée "A 3-D BPSG Flow Simulation with Temperature and Impurity Concentration Dependent Viscosity Model", de Unimoto et al., IEEE 1991.

A l'étape illustrée en figures 7A et 7B, on a formé, dans la tranchée 40, une nouvelle grille de transistor MOS isolée 12. La grille 12 comprend une couche isolante inférieure 14 en surface de laquelle est formée une couche conductrice 16, par exemple en silicium polycristallin dopé. Cette grille peut être formée de nombreuses façons, par exemple en déposant l'ensemble des matériaux formant la grille sous forme de couches minces sur le contour de la structure des figures 6A et 6B, et donc dans la tranchée 40, puis en réalisant une planarisation de la structure (cas représenté en figures 7A et 7B). Le procédé de gravure d'une grille sacrificielle puis de reformation d'une grille de transistor MOS utilisé ici est notamment décrit dans la publication de B. Guillaumot et al. intitulée "75 nm Damascene Metal Gate and High-k Integration for Advanced CMOS Devices", IEDM 2002, pages 355-358.

Une étape ultérieure de suppression du matériau diélectrique 38 permet d'obtenir la structure du transistor MOS M des figures 1A et 1B. Cette étape peut être suivie d'une étape de formation d'un siliciure sur les zones de source et drain si nécessaire.

Les figures 8A et 8B illustrent un résultat d'une variante du procédé décrit ci-dessus permettant de former un transistor MOS M'.

Dans cette variante, le substrat 10 n'est pas un substrat massif mais un substrat de type semiconducteur sur isolant (SOI, Silicon On Insulator). Dans cette configuration, le substrat 10 est une couche semiconductrice qui est formée en surface d'une couche isolante 45, qui s'étend elle-même sur un support semiconducteur 44.

Des régions d'isolement 22 des transistors, définissant la zone active du transistor, s'étendent dans le substrat 10, au travers de la couche isolante 45 et dans le substrat 44 sous-jacent. Des régions 24' en un matériau adapté à appliquer une contrainte sur le canal du transistor M' sont formées dans l'épaisseur du matériau isolant 22. La grille isolée 14-16 du transistor M' est similaire à celle du transistor M des figures 7A et 7B.

La formation des régions 24' en un matériau adapté à appliquer une contrainte sur le canal du transistor M', au travers de la couche isolante 45, permet de former ces régions 24' en réalisant une épitaxie à partir du matériau semiconducteur du support 44.

Pour former la structure des figures 8A et 8B, on réalise des opérations similaires à celles présentées en relation avec les figures 2A à 7A et 2B à 7B, excepté que la gravure des étapes des figures 5A et 5B traverse la couche isolante enterrée 45.

Avantageusement, les procédés présentés ici permettent de former, en surface d'un même substrat, des transistors à canal contraint et à canal non-contraint. Pour cela, le procédé décrit ici sera réalisé après avoir masqué l'ensemble des transistors dont le canal ne doit pas être contraint.

De plus, avantageusement, l'étape de gravure de la grille sacrificielle représentée en figures 4A et 4B est une étape couramment utilisée pour former, sur un même substrat, des grilles isolées de transistors MOS en différents matériaux, par exemple dont la couche isolante est en un matériau à forte ou à faible constante diélectrique ou dont la couche conductrice est constituée d'un empilement de plusieurs matériaux par exemple.

En outre, le fait que les régions de source et de drain des transistors sont formées préalablement à la formation des grilles isolées définitives 12 permet d'éviter que ces grilles isolées ne subissent un traitement thermique trop important. En effet, les régions de source et de drain des transistors sont généralement formées en appliquant des traitements thermiques importants, c'est-à-dire une température élevée, sur la structure. Le procédé présenté ici permet ainsi de former des grilles de transistors en des matériaux qui ne peuvent pas supporter de fortes contraintes thermiques.

Le procédé présenté ici permet donc d'obtenir, en surface d'un même substrat, divers types de transistors MOS dont les canaux assurent une mobilité optimale des porteurs qui s'y déplacent. Ce procédé a l'avantage de ne nécessiter que deux étapes supplémentaires par rapport aux procédés classiques de remplacement d'une grille isolée sacrificielle par une nouvelle grille, à savoir l'étape de gravure des tranchées 42, qui peut même être réalisée en même temps que l'étape de suppression de la portion isolante 32 de la grille sacrificielle si la gravure est compatible, et l'étape de remplissage de ces cavités.

Des modes de réalisation particuliers de la présente invention ont été décrits. Diverses variantes et modifications apparaîtront à l'homme de l'art. En particulier, les diverses étapes de gravure et de dépôt de matériaux pourront être réalisées par tout procédé connu. De plus, en fonction du type de porteurs considéré, et du matériau semiconducteur du canal, l'homme de l'art déterminera aisément le matériau à former dans les régions 24 pour qu'une contrainte adaptée à l'optimisation de la mobilité des porteurs soit appliquée sur le canal.

## Revendications

1. Procédé de fabrication d'un transistor MOS (M, M') à canal contraint, comprenant les étapes suivantes :
(a) former, en surface d'un substrat semiconducteur (10), un transistor MOS comprenant des régions de source et de drain (20) et une grille sacrificielle isolée (30) qui s'étend en partie sur des zones d'isolement (36) entourant le transistor ;
(b) former une couche de matériau diélectrique (38) dont la surface supérieure affleure la surface supérieure de la grille sacrificielle (30) ;
(c) éliminer la grille sacrificielle (30) ;
(d) graver au moins une partie supérieure des zones d'isolement (36) découvertes pour y former des tranchées (42) ;
(e) remplir les tranchées d'un matériau (24, 24') adapté à appliquer une contrainte au substrat ; et
(f) former, dans l'espace laissé libre par la grille sacrificielle, une grille isolée (12) de transistor MOS.

2. Procédé selon la revendication 1, dans lequel l'étape (e) est réalisée en déposant un matériau (24, 24') adapté à appliquer une contrainte sur le substrat sur l'ensemble de la structure puis en gravant l'excédent de ce matériau situé en dehors des tranchées (42).

3. Procédé selon la revendication 1 ou 2, dans lequel les tranchées (42) s'étendent jusqu'au substrat semiconducteur (10) ou jusqu'à un support (44) de structure semiconducteur sur isolant, et le remplissage des tranchées à l'étape (e) est réalisé par épitaxie du matériau (24, 24') adapté à appliquer une contrainte à partir du fond des tranchées.

4. Procédé selon l'une quelconque des revendications 1 à 3, dans lequel le substrat (10) est un substrat massif.

5. Procédé selon l'une quelconque des revendications 1 à 3, dans lequel le substrat (10) est un substrat de type semiconducteur sur isolant.

6. Procédé selon l'une quelconque des revendications 1 à 5, dans lequel le matériau (24, 24') adapté à appliquer une contrainte sur le substrat est du nitrure de silicium, du silicium-germanium, ou un matériau dont la structure est adaptée à fluer par suite d'un recuit.

7. Procédé selon l'une quelconque des revendications 1 à 6, dans lequel l'étape (f) est précédée ou suivie d'une étape d'élimination de la couche de matériau diélectrique (38).

## Claims

1. A method for manufacturing a strained channel MOS transistor (M, M'), comprising the steps of:
(a) forming, at the surface of a semiconductor substrate (10), a MOS transistor comprising source and drain regions (20) and an insulated sacrificial gate (30) which partly extends over insulation areas (36) surrounding the transistor;
(b) forming a layer of a dielectric material (38) having its upper surface level with the upper surface of the sacrificial gate (30);
(c) removing the sacrificial gate (30);
(d) etching at least an upper portion of the exposed insulation areas (36) to form trenches therein (42);
(e) filling the trenches with a material (24, 24') capable of straining the substrate; and
(f) forming, in the space left free by the sacrificial gate, an insulated MOS transistor gate (12).

2. The method of claim 1, wherein step (e) is carried out by depositing a material (24, 24') capable of straining the substrate over the entire structure, and by then etching the excess material located outside of the trenches (42).

3. The method of claim 1 or 2, wherein the trenches (42) extend all the way to the semiconductor substrate (10), or all the way to a semiconductor-on-insulator structure support (44), and the filling of the trenches at step (e) is performed by epitaxy of the material (24, 24') capable of applying a strain from the bottom of the trenches.

4. The method of any of claims 1 to 3, wherein the substrate (10) is a solid substrate.

5. The method of any of claims 1 to 3, wherein the substrate (10) is a substrate of semiconductor-on-insulator type.

6. The method of any of claims 1 to 5, wherein the material (24, 24') capable of straining the substrate is silicon nitride, silicon-germanium, or a material having a structure capable of reflowing after an anneal.

7. The method of any of claims 1 to 6, wherein step (f) is preceded or followed by a step of removal of the dielectric material layer (38).

## Patentansprüche

1. Ein Verfahren zum Herstellen eines kanalverspannten, auch strained channel, MOS Transistors (M, M'), welches die Folgenden Schritte aufweist:
(a) Bilden, auf der Oberfläche eines Halbleitersubstrates (10), eines MOS Transistors der Source- und Drainregionen (20) und ein isoliertes Opfergate, auch sacrificial gate, (30) aufweist, welches sich teilweise über den Transistor umgebende Isolationsgebiete (36) ausdehnt;
(b) Bilden einer Schicht aus einem dielektischen Material (38), die einen obereren Oberflächenlevel mit der oberen Oberfläche des Opfergates (30) hat;
(c) Entfernen des Opfergates (30);
(d) Ätzen von mindestens einem oberen Teil der freigelegten Isolationsgebiets (36) um darin Gräben, auch Trenches, (42) zu bilden;
(e) Füllen der Gräben mit einem Material (24, 24') welches fähig ist, das Substrat zu verspannen; und
(f) Bilden eines isolierten MOS Transistorgates (12) in dem von dem Opfergate freigelassenen Raum.

2. Verfahren nach Anspruch 1, wobei der Schritt (e) durch Abscheiden eines Materials (24, 24') ausgeführt wird, welches fähig ist, das Substrat über die gesamte Struktur zu verspannen und durch anschließendes Ätzen des überschüssigen Materials, welches sich ausserhalb der Gräben (42) befindet.

3. Verfahren nach Anspruch 1 oder 2, wobei sich die Gräben (42) den gesamten Weg zum Halbleitersubstrat (10) erstrecken, oder sich den ganzen Weg zu einer Halbleiterisolationsunterstützungsstruktur (44) erstrecken, und das Füllen der Gräben im Schritt (e) durch Epitaxie von Material (24,24') erfolgt, welches in der Lage ist, eine Verspannung von dem Boden der Gräben her anzulegen.

4. Verfahren nach einem der Ansprüche 1 bis 3, wobei das Substrat (10) ein massives Substrat ist.

5. Verfahren nach einem der Ansprüche 1 bis 3, wobei das Substrat (10) ein Substrat vom Typ Halbleiter-auf-Isolator ist.

6. Verfahren nach einem der Ansprüche 1 bis 5, wobei das zum Verspannen des Substrats fähige Material (24,24') Siliziumnitrid, Silizium-Germanium oder ein Material ist, welches eine Struktur hat, die nach dem Tempern bzw. Annealen fähig ist, aufzuschmelzen.

7. Verfahren nach einem der Ansprüche 1 bis 6, wobei der Schritt (f) einem Schritt des Entfernens der Schicht (38) des dielektrischen Materials vorhergeht oder nachfolgt.
